# EUROPÄISCHE PATENTSCHRIFT

(11) **EP 1 636 859 B1**
(45) Veröffentlichungstag und Bekanntmachung des Hinweises auf die Patenterteilung: **31.10.2007**
(21) Anmeldenummer: 05726210.7
(22) Anmeldetag: 07.04.2005
(51) Int. Cl.: H01L 41/047, H01L 41/083

(54) **PIEZOELEKTRISCHES BAUTEIL MIT SOLLBRUCHSTELLE, VERFAHREN ZUM HERSTELLEN DES BAUTEILS UND VERWENDUNG DES BAUTEILS**
PIEZOELECTRIC COMPONENT WITH A PREDETERMINED BREAKING POINT, METHOD FOR PRODUCING THE COMPONENT AND USE OF THE COMPONENT
ELEMENT PIEZOELECTRIQUE AVEC UN POINT DE RUPTURE PREVU, METHODE DE PRODUCTION DE L'ELEMENT, ET UTILISATION DE L'ELEMENT

(30) Priorität: 29.06.2004 DE 102004031402
(43) Veröffentlichungstag der Anmeldung: 22.03.2006
(73) Patentinhaber: SIEMENS AKTIENGESELLSCHAFT, 80333 München (DE)
(72) Erfinder: KASTL, Harald, Johannes, 95686 Fichtelberg (DE); SCHUH, Carsten, 85598 Baldham (DE)
(86) Internationale Anmeldenummer: PCT/EP2005/051541
(87) Internationale Veröffentlichungsnummer: WO 2006/000479

(56) Entgegenhaltungen:
- WO-A-01/01499
- DE-A1- 19 648 545
- PATENT ABSTRACTS OF JAPAN Bd. 008, Nr. 039 (E-228), 21. Februar 1984 (1984-02-21) -& JP 58 196077 A (NIPPON DENKI KK), 15. November 1983 (1983-11-15)
- PATENT ABSTRACTS OF JAPAN Bd. 015, Nr. 355 (E-1109), 9. September 1991 (1991-09-09) -& JP 03 138987 A (NEC CORP), 13. Juni 1991 (1991-06-13)
- PATENT ABSTRACTS OF JAPAN Bd. 013, Nr. 117 (E-731), 22. März 1989 (1989-03-22) -& JP 63 288075 A (NEC CORP), 25. November 1988 (1988-11-25)

## Beschreibung

Die Erfindung betrifft ein piezoelektrisches Bauteil mit mindestens einem monolithischen Piezoelement, ein Verfahren zum Herstellen des Bauteils und eine Verwendung des Bauteils.

Das piezoelektrische Bauteil ist beispielsweise ein piezoelektrischer Aktor (Piezoaktor) mit einem monolithischen Aktorkörper aus einer Vielzahl von übereinander gestapelten monolithischen Piezoelementen. Ein Piezoelement besteht aus einer Elektrodenschicht, mindestens einer weiteren Elektrodenschicht und mindestens einer zwischen den Elektrodenschichten angeordneten Piezokeramikschicht. Die Piezokeramikschicht und die Elektrodenschichten des Piezoelements sind derart miteinander verbunden, dass durch eine elektrische Ansteuerung der Elektrodenschichten ein elektrisches Feld in die Piezokeramikschicht eingekoppelt wird. Aufgrund des eingekoppelten elektrischen Feldes kommt es zur Auslenkung der Piezokeramikschicht und damit zur Auslenkung des Piezoelements.

Ein beschriebener piezoelektrischer Aktor ist beispielsweise aus der DE 100 26 635 A1 bekannt. Bei dem piezoelektrischen Aktor sind die Piezoelemente in einer Stapelrichtung übereinander zu einem monolithischen Aktorkörper angeordnet. Dabei eine Vielzahl von Elektrodenschichten, die als Innenelektroden bezeichnet werden, und eine Vielzahl von Piezokeramikschichten sind abwechselnd übereinander gestapelt und gemeinsam zu dem monolithischen Aktorkörper gesintert. Die Piezokeramikschichten bestehen aus einem Bleizirkonattitanat (Pb(Ti, Zr)O₃, PZT). Die Elektrodenschichten bestehen aus einer Silber-Palladium-Legierung. Zur elektrischen Kontaktierung der Elektrodenschichten sind in Stapelrichtung benachbarte Elektrodenschichten abwechselnd an zwei elektrisch voneinander isolierte, seitliche Oberflächenabschnitte des Aktorkörpers geführt. An diesen Oberflächenabschnitten weist der Aktorkörper jeweils eine streifenförmige Metallisierung auf.

Im Bereich der beschriebenen Oberflächenabschnitte des Aktorkörpers ist jedes der Piezoelemente piezoelektrisch inaktiv. Aufgrund der abwechselnden Führung der Elektrodenschichten an die Oberflächenabschnitte wird in einen piezoelektrisch inaktiven Bereich der piezoelektrischen Schicht ein elektrisches Feld eingekoppelt, das sich deutlich von dem elektrischen Feld unterscheidet, das in einen piezoelektrisch aktiven Bereich der Piezokeramikschicht eingekoppelt wird. Der piezoelektrisch aktive Bereich der Piezokeramikschicht befindet sich im Gegensatz zum piezoelektrisch inaktiven Bereich direkt zwischen den Elektrodenschichten des Piezoelements.

Bei der elektrischen Ansteuerung der Elektrodenschichten, also beim Polarisieren der Piezokeramik und/oder im Betrieb des Piezoaktors, kommt es aufgrund der unterschiedlichen elektrischen Felder zu unterschiedlichen Auslenkungen der Piezokeramikschicht im piezoelektrisch aktiven Bereich und im piezoelektrisch inaktiven Bereich. Als Folge davon treten mechanische Spannungen im Piezoelement auf, die zu einem sogenannten Polungsriss quer zur Stapelrichtung oder zu einem Risswachstum eines bereits vorhandenen Risses führen können. Dabei kann sich der Polungsriss bis in die an dem jeweiligen Oberflächenabschnitt des Aktorkörpers angebrachte Metallisierung fortsetzen. Dies führt zu einer Unterbrechung der elektrischen Kontaktierung zumindest eines Teils der Elektrodenschichten des Aktorkörpers.

Damit ein vorhandener Polungsriss im Aktorkörper nicht zu einem Ausfall des Piezoaktors führt, ist bei dem bekannten Piezoaktor an den seitlich angebrachten Metallisierungen des Aktorkörpers jeweils ein flexibles elektrisches Anschlusselement angebracht. Jedes der flexiblen Anschlusselemente weist eine Vielzahl von elektrisch leitfähigen Drähten auf. Entlang der Stapelrichtung des Aktorkörpers sind die Drähte eines Anschlusselements an einer der Metallisierungen angelötet. Die Drähte sorgen für die elektrische Kontaktierung der Elektrodenschichten des Aktorkörpers (mittelbar über die jeweilige Metallisierung). Zur elektrischen Kontaktierung der Drähte des Anschlusselements ist ein starrer, entlang der Stapelrichtung des Aktorkörpers ausgerichteter, elektrischer Anschlussstift vorhanden, an den die Drähte gelötet sind. Die Kontaktierung der Drähte und der Innenelektroden des Aktorkörpers ist auch dann gewährleistet, wenn es durch die Auslenkung des Aktorkörpers (Expansion und Kontraktion entlang der Stapelrichtung) zu einem Polungsriss quer zur Stapelrichtung bzw. zum Wachstum eines vorhandenen Polungsrisses quer zur Stapelrichtung kommt.

Eine ähnliche Lösung geht aus DE 196 48 545 A1 hervor. An den Metallisierungen sind dreidimensional strukturierte, flexible elektrische Anschlusselemente angebracht. Solche Anschlusselemente sind beispielsweise ein Drahtgeflecht oder ein offenporiger Metallschaum.

Eine dazu alternative Lösung ist aus WO 01/01499 A1 bekannt. Dabei sind die Enden der Elektrodenschichten zu den Metallisierungen hin kugelförmig verdickt. Dies bewirkt, dass sich an einer Grenzfläche zwischen der Elektrodenschicht und benachbarter Piezokeramikschicht nicht in die Metallisierung fortsetzt. Das Risswachstum des gebildeten Risses kommt an den verdickten Stellen zu Stillstand.

Allerdings kann es im dynamischen Betrieb des beschriebenen piezoelektrischen Aktors zu einer Ablenkung eines vorhandenen Polungsrisses kommen. Der Polungsriss wächst unkontrolliert. Beispielsweise wächst der Polungsriss nicht quer zur Stapelrichtung sondern parallel oder annähernd parallel zur Stapelrichtung. Es bilden sich Längsrisse im Aktorkörper. Das unkontrollierte Wachstum eines Polungsrisses kann auf ungünstigen intrinsischen und/oder extrinsischen Einflussgrößen beruhen. Intrinsische Einflussgrößen betreffen beispielsweise eine Gefügestruktur einer Piezokeramikschicht und/oder einer Elektrodenschicht. Die Gefügestruktur kann innerhalb der jeweiligen Schicht zu einem anisotropen Risswiderstand führen. Der Risswiderstand ist innerhalb der Schicht in unterschiedlichen Richtungen verschieden. Extrinsische Einflussgrößen basieren beispielsweise auf einer elektrischen Anstiegsflanke im dynamischen Betrieb oder auf einer unzureichenden Klemmung des Aktorkörpers.

Als Folge des unkontrollierten Wachstums eines Polungsrisses kann es zum Ausfall des piezoelektrischen Aktors kommen. Eine Zuverlässigkeit des Aktors ist nicht gewährleistet.

Aufgabe der vorliegenden Erfindung ist daher es, ein im Vergleich zum Stand der Technik zuverlässigeres piezoelektrisches Bauteil aus monolithischen Piezoelementen bereitzustellen.

Zur Lösung der Aufgabe wird ein piezoelektrisches Bauteil mit mindestens einem monolithischen Piezoelement angegeben, aufweisend eine Elektrodenschicht, mindestens eine weitere Elektrodenschicht, mindestens eine zwischen den Elektrodenschichten angeordnete Piezokeramikschicht und mindestens eine Sollbruchstelle, die bei mechanischer Überlastung des Piezoelements zur Bildung eines bestimmten Risses im monolithischen Piezoelement führt, wobei die Sollbruchstelle die Elektrodenschicht aufweist.

Zur Lösung der Aufgabe wird auch ein Verfahren zum Herstellen des Bauteils mit folgenden Verfahrensschritten angegeben: a) Bereitstellen einer eine Piezokeramik aufweisenden keramischen Grünfolie mit einer Hauptfläche und einer der Hauptfläche abgekehrten weiteren Hauptfläche, b) Anordnen von elektrisch leitfähigem Material an der Hauptfläche und Anordnen von weiterem elektrisch leitfähigen Material an der weiteren Hauptfläche der keramischen Grünfolie und c) gemeinsames Sintern der keramischen Grünfolie und der elektrisch leitfähigen Materialien, wobei aus dem elektrisch leitfähigen Material die Elektrodenschicht, dem weiteren elektrisch leitfähigen Material die weitere Elektrodenschicht und aus der keramischen Grünfolie die Piezokeramikschicht des Piezoelements gebildet werden.

Die Sollbruchstelle ist ein Bestandteil des Piezoelements, der bei Überlastung, vergleichbar mit einer Sicherung, durch Bildung eines Risses bzw. durch Wachstum eines vorhandenen Risses zerstört wird. Dabei ist der Riss im Wesentlichen auf die Sollbruchstelle beschränkt. Es wird nur die Sollbruchstelle zerstört, nicht aber das ganze Piezoelement oder andere Bereiche des Piezoelements. Der Riss ist lokal auf die Sollbruchstelle beschränkt und breitet sich nicht in andere Bereiche des Piezoelements aus. Dadurch ist es möglich die Bildung eines Risses bzw. das Wachstum eines Risses zu kontrollieren.

Der Riss führt zu einem Bruch des monolithischen Piezoelements an der Sollbruchstelle. Der Bruch ist ein Vorgang, der einer mechanisch induzierten Verformung eines Werkstoffs ein Ende setzt. Der Bruch ist insbesondere ein Sprödbruch. Der Sprödbruch kann durch Kriechen (Kriechbruch) und insbesondere durch Ermüdung (Ermüdungsbruch) verursacht werden. Unter Ermüdung wird ein Versagen von Werkstoffen durch fortschreitendes Risswachstum verstanden, das durch wiederholte (mechanische) Spannungszyklen verursacht wird.

An der Sollbruchstelle ist ein wesentlicher Bestandteil des Piezoelements beteiligt, nämlich eine der Elektrodenschichten. Dies bedeutet, dass kein zusätzlicher Bestandteil zur Bildung der Sollbruchstelle des Piezoelements eingeführt werden muss. Der zusätzliche Bestandteil des Piezoelements könnte zu einer Reduzierung eines piezoelektrischen aktiven Volumens des Piezoelements führen. Ein derartiger zusätzlicher Bestandteil wäre beispielsweise eine keramische Sicherheitsschicht des Piezoelements aus einem piezoelektrisch inaktiven keramischen Material, das sich durch einen im Vergleich zur Piezokeramik der piezokeramischen Schicht niedrigeren Risswiderstand auszeichnet.

In einer besonderen Ausgestaltung ist die Sollbruchstelle von der Elektrodenschicht und/oder von einer Grenzfläche zwischen der Elektrodenschicht und der Piezokeramikschicht gebildet.

Insbesondere für den Fall, dass die Sollbruchstelle von der Elektrodenschicht gebildet ist, ist ein Risswiderstand der Elektrodenschicht kleiner als ein weiterer Risswiderstand der weiteren Elektrodenschicht. Dies bedeutet, dass eine Bruchfestigkeit eines Elektrodenmaterials der Elektrodenschicht kleiner ist als eine Bruchfestigkeit eines weiteren Elektrodenmaterials der weiteren Elektrodenschicht. Ebenso ist die Bruchfestigkeit des Elektrodenmaterials kleiner als eine Bruchfestigkeit der Piezokeramikschicht. Die niedrigere Bruchfestigkeit des Elektrodenmaterials im Vergleich zum weiteren Elektrodenmaterial und zur Piezokeramik führt dazu, dass die Sollbruchstelle in der Elektrodenschicht vorhanden ist. Die Elektrodenschicht ist das schwächste Glied. Bei mechanischer Überlastung entsteht ein Riss in der Elektrodenschicht.

Für den Fall, dass die Sollbruchstelle von der Grenzfläche zwischen der Elektrodenschicht und der Piezokeramikschicht gebildet ist, ist eine Haftfestigkeit der Elektrodenschicht und der Piezokeramikschicht aneinander kleiner als eine weitere Haftfestigkeit der weiteren Elektrodenschicht und der Piezokeramikschicht aneinander. Die Grenzfläche zwischen der Elektrodenschicht und der Piezokeramikschicht ist das schwächste Glied. Bei mechanischer Überlastung entsteht ein Riss an der Grenzfläche zwischen der Elektrodenschicht und der Piezokeramikschicht.

Um unterschiedliche Risswiderstände bzw. Haftfestigkeiten zu erzielen, unterscheiden sich in einer besonderen Ausgestaltung ein Elektrodenwerkstoff der Elektrodenschicht und ein weiterer Elektrodenwerkstoff der weiteren Elektrodenschicht. Die Elektrodenschichten bestehen aus unterschiedlichen Elektrodenwerkstoffen. Insbesondere unterscheiden sich dabei der Elektrodenwerkstoff und der weitere Elektrodenwerkstoff in ihrer chemischen Zusammensetzung und/oder in ihrer Materialstruktur voneinander. Die Materialstruktur betrifft beispielsweise einen Aufbau (z.B. Core-Shell-Struktur) und eine Größe bzw. eine Größenverteilung von Körnern des Elektrodenwerkstoffs sowie ein Gefüge des Elektrodenwerkstoffs. Das Gefüge betrifft beispielsweise eine Porosität des Elektrodenwerkstoffs. Eine unterschiedliche Porosität des Elektrodenwerkstoffs lässt sich beispielsweise durch Verwendung unterschiedlicher Metallpasten bei der Herstellung des Piezoelements realisieren. Die Metallpasten werden zur Bildung der Elektrodenschichten auf eine oder mehrere Elektrodenschichten gedruckt. Die unterschiedlichen Metallpasten zeichnen sich beispielsweise durch unterschiedliche Binder- und/oder Feststoffgehalte aus. Als Binder und/oder Feststoffe werden beispielsweise Stoffe eingesetzt, die sich beim Sintern zersetzen. Derartige Stoffe bestehen beispielsweise aus Kohlenstoff oder Kohlenwasserstoffen. Beispielsweise beinhalten die Metallpasten Kunststoffkügelchen. Ein durchschnittlicher Partikeldurchmesser beträgt 0,1 µm bis 2,0 µm. Beim Entbindern bzw. beim Sintern brennen die Kunststoffkügelchen aus. Es verbleiben in den beim Sintern entstehenden Elektrodenschichten Poren. Unterschiedliche Porenanteile und/oder Porengrößen führen zu unterschiedlichen Risswiderständen und Haftfestigkeiten.

Die chemische Zusammensetzung der Elektrodenwerkstoffe betrifft insbesondere ein elektrisch leitfähiges Elektrodenmaterial der Elektrodenwerkstoffe. Die Elektrodenschichten weisen unterschiedliche elektrisch leitfähige Elektrodenmaterialien auf. Die unterschiedlichen Elektrodenmaterialien können aus unterschiedlichen Elementen bestehen. Beispielsweise ist das Elektrodenmaterial der Elektrodenschicht Platin und das weitere Elektrodenmaterial der weiteren Elektrodenschicht eine Silber-Palladium-Legierung- Platin zeichnet sich beispielsweise durch eine im Vergleich zu einer Silber-Palladium-Legierung deutlich schlechteren Haftung an Bleizirkonattitanat aus. Dadurch resultiert eine geringere Haftfestigkeit zwischen der Elektrodenschicht mit Platin und der Piezokeramikschicht aus Bleizirkonattitanat gegenüber der Haftfestigkeit der weiteren Elektrodenschicht mit der Silber-Palladium-Legierung und der Piezokeramikschicht.

Denkbar ist aber auch, dass die unterschiedlichen Elektrodenmaterialien der Elektrodenwerkstoffe nicht unterschiedlichen Materialsystemen, sondern einem gleichen Materialsystem entspringen. Die Elektrodenmaterialien weisen gleiche Elemente auf. Allerdings sind die Elementanteile der Elemente von Elektrodenmaterial zu Elektrodenmaterial unterschiedlich. Beispielsweise sind das elektrisch leitfähige Elektrodenmaterial des Elektrodenwerkstoffs und das elektrisch leitfähige Elektrodenmaterial des weiteren Elektrodenwerkstoffs jeweils eine Silber-Palladium-Legierung, allerdings mit unterschiedlichen Elementanteilen an Silber und Palladium.

Die unterschiedliche chemische Zusammensetzung der Elektrodenwerkstoffe kann neben dem elektrisch leitfähigen Elektrodenmaterial auch einen Zusatzstoff zum elektrisch leitfähigen Elektrodenmaterial betreffen. Beispielsweise ist das elektrisch leitfähige Elektrodenmaterial beider Elektrodenschichten identisch. Eine der Elektrodenschichten besteht aber nur aus dem elektrisch leitfähigen Elektrodenmaterial, die andere Elektrodenschicht dagegen aus einem Verbundwerkstoff mit dem elektrisch leitfähigem Elektrodenmaterial und dem Zusatzstoff.

Beispielsweise ist die Piezokeramik der Piezokeramikschicht ein Bleizirkonattitanat. Beim Sintern von Bleizirkonattitanat wird Bleioxid (PbO) frei. Durch Zirkonattitanat ((Ti, Zr)O₂, ZTO) als Zusatzstoff zum Elektrodenmaterial wird das beim Sintern frei werdende Bleioxid des Bleizirkonattitanats gebunden. Es bildet sich Bleizirkonattitanat, das die Haftfestigkeit an der Grenzfläche zur Piezokeramikschicht aus Bleizirkonattitanat erhöht. Zur Erhöhung der Haftfestigkeit kann auch direkt Bleizirkonattitanat als Zusatzstoff eingesetzt werden. Mit den genannten Zusatzstoffen wird bevorzugt die weitere Elektrodenschicht ausgestattet. Dadurch resultierte eine verbesserte Haftfestigkeit der weiteren Elektrodenschicht an der Piezokeramikschicht. Die Grenzfläche zwischen der Elektrodenschicht ohne solche Zusatzstoffe wird zur Sollbruchstelle.

In einer weiteren Ausgestaltung unterscheiden sich eine Elektrodenstruktur der Elektrodenschicht und eine weitere Elektrodenstruktur der weiteren Elektrodenschicht voneinander. Durch unterschiedlich strukturierte Elektrodenschichten wird dafür gesorgt, dass die Elektrodenschicht einen niedrigeren Risswiderstand aufweist als die weitere Elektrodenschicht bzw. zwischen der Elektrodenschicht und der Piezokeramikschicht eine niedrigere Haftfestigkeit besteht als zwischen der weiteren Elektrodenschicht und der Piezokeramikschicht. Dazu sind die Elektrodenschichten beispielsweise rasterförmig oder lochmaskenähnlich strukturiert. Solche unterschiedlichen Elektrodenstrukturen lassen sich beispielsweise beim Bedrucken der keramischen Grünfolien mit den Metallpasten durch unterschiedliche Bedruckungsdesigns erhalten.

Durch unterschiedliche Schichtdicken der Elektrodenschichten können ebenfalls Risswiderstand und Haftfestigkeit beeinflusst werden. Daher betrifft in einer besonderen Ausgestaltung die Elektrodenstruktur eine Elektrodenschichtdicke und die weitere Elektrodenstruktur eine weitere Elektrodenschichtdicke. Dabei kann jede der Elektrodenschichten durchgängig eine annähernd gleiche Elektrodenschichtdicke aufweisen. Denkbar ist auch, dass die Elektrodenschichtdicken innerhalb einer Elektrodenschicht unterschiedlich sind. Beispielsweise besteht ein Gradient der Elektrodenschichtdicke entlang einer lateralen Ausdehnung der Elektrodenschicht oder der weiteren Elektrodenschicht.

In einer besonderen Ausgestaltung ist eine Vielzahl von Piezoelementen zu einem monolithischen, stapelförmigen Aktorkörper mit einer Stapelrichtung angeordnet. Die Piezoelemente sind übereinander zu dem Aktorkörper gestapelt. Dabei kann der Aktorkörper nur aus Piezoelementen mit jeweils einer Sollbruchstelle aufgebaut sein. In einer besonderen Ausgestaltung sind das Piezoelement und zumindest ein weiteres Piezoelement zu einem monolithischen, stapelförmigen Aktorkörper mit einer Stapelrichtung angeordnet, wobei das weitere Piezoelement mindestens zwei weitere Elektrodenschichten und mindesten eine zwischen den weiteren Elektrodenschichten angeordnete weitere Piezokeramikschicht aufweist. Die weitere Piezokeramikschicht kann aus einem anderen piezokeramischen Material bestehen als die Piezokeramikschicht des Piezoelements mit der Sollbruchstelle. Vorzugsweise weisen aber das Piezoelement und das weitere Piezoelement das gleiche piezokeramische Material auf. Da die weiteren Elektrodenschichten gleich sind, ist in dem weiteren Piezoelement zumindest bezüglich der Elektrodenschichten keine Sollbruchstelle realisiert. Vorzugsweise werden wesentlich mehr weitere Piezoelemente ohne Sollbruchstelle als Piezoelemente mit Sollbruchstelle übereinander angeordnet. Es resultiert ein Aktorkörper, bei dem einige wenige Sollbruchstellen vorhanden sind. Diese Sollbruchstellen sind entlang der Stapelrichtung über den Aktorkörper verteilt.

In einer weiteren Ausgestaltung sind eine Vielzahl der Piezoelemente und eine Vielzahl der weiteren Piezoelemente derart zu dem monolithischen, stapelförmigen Aktorkörper angeordnet, dass benachbarte Piezoelemente jeweils mindestens eine gemeinsame Elektrodenschicht aufweisen und die gemeinsamen Elektrodenschichten in Stapelrichtung des Aktorkörpers abwechselnd an mindestens zwei voneinander elektrisch isolierte, seitliche Oberflächenabschnitte des Aktorkörpers geführt sind. Ein seitlicher Oberflächenabschnitt des Aktorkörpers wird beispielsweise von einer Seitenfläche oder von einer Kante des Aktorkörpers gebildet, auf der eine Metallisierungsbahn aufgebracht ist. Es liegt ein Aktorkörper mit einer Mehrschichtkondensatorstruktur vor. Innerhalb dieser Mehrschichtkondensatorstruktur sind die Elektrodenschichten abwechselnd an voneinander elektrisch isolierte Oberflächenabschnitte geführt.

In einer besonderen Ausgestaltung sind mehrere Piezoelemente derart zum Aktorkörper mit einer Anzahl von Sollbruchstellen angeordnet, dass die Sollbruchstellen entlang der Stapelrichtung des Aktorkörpers einen Gradienten bezüglich der mechanischen Überlastung aufweisen, bei der es jeweils zur Bildung eines Risses kommt. Es liegt ein Festigkeitsgradient vor. Diese Ausgestaltung ist dann vorteilhaft, wenn entlang der Stapelrichtung ein entsprechender Gradient der mechanischen Belastung des Aktorkörpers auftritt. Zum Erzeugen des Festigkeitsgradienten kann auf die oben angegebenen Möglichkeiten zur Beeinflussung der Festigkeit der einzelnen Elektrodenschichten und der Grenzflächen zurückgegriffen werden. Darüber hinaus kann durch gezielte Prozessführung bei der Herstellung des Aktorkörpers das Ausbilden des Festigkeitsgradienten gefördert werden. So kann beispielsweise beim gemeinsamen Sintern von Bleizirkonattitanat und Elektrodenmaterial einer Silber-Palladium-Legierung die Bildung einer amorphen Blei-Palladiumoxid-Zwischenschicht zwischen der Elektrodenschicht und der Piezokeramikschicht forciert werden.

In einer weiteren Ausgestaltung ist die Sollbruchstelle zumindest eines der Piezoelemente des Aktorkörpers derart ausgestaltet, dass ein in dem Piezoelement auftretender Riss den Aktorkörper in mindestens zwei Teilstapel unterteilt und die Elektrodenschichten des jeweiligen Teilstapels, die an einen gemeinsamen seitlichen Oberflächenabschnitt geführt sind, mit Hilfe eines elektrischen Teil-Anschlusselements elektrisch kontaktiert bleiben. Das Teil-Anschlusselement ist mit Hilfe eines elektrisch leitfähigen Verbindungsmittels an den seitlichen Oberflächenabschnitt elektrisch und mechanisch kontaktiert. Das elektrisch leitfähige Verbindungsmittel ist beispielsweise ein Leitklebstoff oder ein Lot. Das Teil-Anschlusselement ist an den Oberflächenabschnitt geklebt oder gelötet. Ein Verbinden durch Schweißen ist ebenfalls denkbar.

Das elektrische Teil-Anschlusselement ist vorzugsweise ein flexibles Teil-Anschlusselement. Damit ist das Teil-Anschlusselement in der Lage, der Expansion und der Kontraktion des Teilstapels des Aktorkörpers zu folgen.

Das flexible Teil-Anschlusselement wird beispielsweise von einer strukturierten elektrisch leitfähigen Folie gebildet. In einer besonderen Ausgestaltung weist das elektrische Teil-Anschlusselement mindestens einen elektrisch leitfähigen Draht auf. Beispielsweise besteht das Teil-Anschlusselement aus einer Vielzahl von Drähten oder einem Drahtgeflecht. Denkbar ist insbesondere auch ein Teil-Anschlusselement in Form eines einzigen Drahtes. Der Draht ist dabei so dimensioniert, dass eine für die Ansteuerung der zu kontaktierenden Elektrodenschichten des Teilstapels notwendige Stromtragfähigkeit gewährleistet ist.

Darüber hinaus ist der Draht bzw. das Drahtgeflecht und die Verbindung an den seitlichen Oberflächenabschnitt des Aktorkörper im Hinblick auf die bei der Expansion und Kontraktion des Teilstapels zu erwartenden mechanischen Spannungen gestaltet. Diese mechanischen Spannungen können von Teilstapel zu Teilstapel unterschiedlich sein. Somit ergeben sich unterschiedliche Anforderungen an das Teil-Anschlusselement und deren Anbindung an den Oberflächenabschnitt. Bei einem Teilstapel eines ruhenden Bereichs des Aktorkörpers, in dem durch die Ansteuerung der Elektrodenschichten eine nur geringe Auslenkung des Teilstapels hervorruft wird, genügt es beispielsweise, einen einzigen und dafür relativ dicken Draht zur elektrischen Kontaktierung der Elektrodenschichten zu verwenden. Dagegen kann es vorteilhaft sein, bei einem Teilstapel eines Bereichs des Aktorkörpers, bei dem eine große Auslenkung auftritt, mehrere dünne und damit flexiblere Drähte einzusetzen.

Um Elektrodenschichten unterschiedlicher Teilstapel mit dem gleichen elektrischen Potential zu versorgen, sind die entsprechenden Teil-Anschlusselemente zu einem gemeinsamen Anschlusselement zusammengefasst. Dazu sind beispielsweise die Drähte mit Hilfe eines weiteren Verbindungsmittels an einen gemeinsamen starren elektrischen Anschlussstift elektrisch leitend und kraftschlüssig angelötet oder angeklebt. Das elektrische Anschlusselement bzw. die elektrischen Teil-Anschlusselemente liegen als Drahtharfe vor.

Bezüglich des Verfahrens wird zum Anordnen des elektrisch leitfähigen Materials und/oder zum Anordnen des weiteren elektrisch leitfähigen Materials jeweils eine Metallpaste mit unterschiedlicher Zusammensetzung verwendet. Die Metallpaste wird auf eine oder mehrere keramische Grünfolien aufgedruckt. Zum Aufdrucken wird beispielsweise ein Siebdruckverfahren durchgeführt. Das Elektrodenmaterial und/oder das weitere Elektrodenmaterial kann dabei unterschiedlich strukturiert, beispielsweise mit einer unterschiedlichen Schichtdicke, aufgetragen werden. Vorzugsweise wird unterschiedliches Elektrodenmaterial aufgedruckt. Beispielsweise besteht das Elektrodenmaterial aus einer Silber-Palladium-Legierung, dagegen das Elektrodenmaterial der weiteren Elektrodenschicht aus einer Platin-Legierung. Da diese Materialien unterschiedlich fest an die beim Sintern entstehende Piezokeramikschicht anbinden, entstehen Grenzflächen mit unterschiedlicher Haftfestigkeit.

Das beschriebene piezoelektrische Bauteil, insbesondere der piezoelektrische Aktor mit dem Aktorkörper in monolithischer Vielschichtbauweise wird vorzugsweise zum Ansteuern eines Ventils und insbesondere zum Ansteuern eines Einspritzventils einer Brennkraftmaschine verwendet.

Zusammenfassend ergeben sich mit der Erfindung folgende wesentlichen Vorteile:
- Mit Hilfe der Sollbruchstellen gelingt es, Rissbildung und Risswachstum (insbesondere von Längsrissen) in einem piezoelektrischen Bauteil zu kontrollieren und zu begrenzen. Es resultiert ein im Vergleich zum Stand der Technik zuverlässigeres Bauteil.
- Dadurch, dass die Sollbruchstellen unter Einbindung der Elektrodenschichten realisiert werden, steht ein piezoelektrisches Bauteil mit einem maximal möglichen piezoelektrischen aktiven Volumen zur Verfügung.
- Durch die Kontrolle der Risse vereinfacht sich die elektrische Kontaktierung der Elektrodenschichten des Bauteils.
- Das Verfahren zum Herstellen des piezoelektrischen Bauteils mit den Sollbruchstellen kann in bestehende Herstellverfahren für Piezoaktoren integriert werden.

Anhand eines Ausführungsbeispiels und der dazugehörigen Figuren wird die Erfindung im Folgenden näher beschrieben. Die Figuren sind schematisch und stellen keine maßstabsgetreuen Abbildungen dar.
- Figur 1: zeigt ein Piezoelement und ein weiteres Piezoelement jeweils im seitlichen Querschnitt.
- Figuren 2A und 2B: zeigen einen Ausschnitt einer Sollbruchstelle mit Elektrodenschicht, an bzw. in der ein Riss entstanden ist.
- Figur 3: zeigt einen Ausschnitt eines piezoelektrischen Bauteils in Form eines Piezoaktors mit einem Aktorkörper in monolithischer Vielschichtbauweise von der Seite.

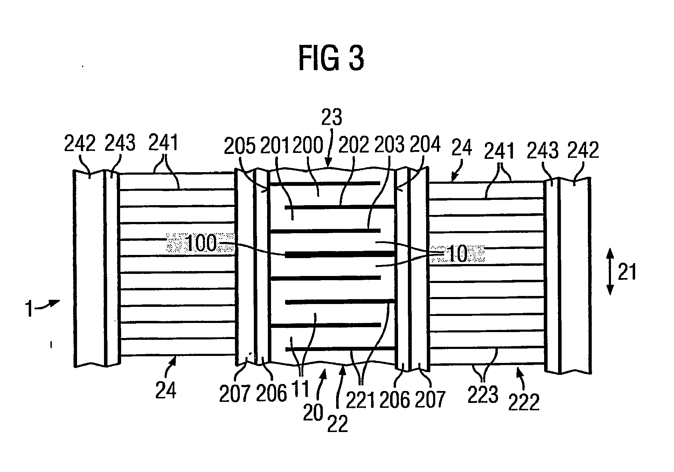

Das piezoelektrische Bauteil 1 ist ein piezoelektrischer Aktor mit einem Aktorkörper 20 in monolithischer Vielschichtbauweise (Figur 3). Eine Grundfläche des Aktorkörpers 20 ist quadratisch.

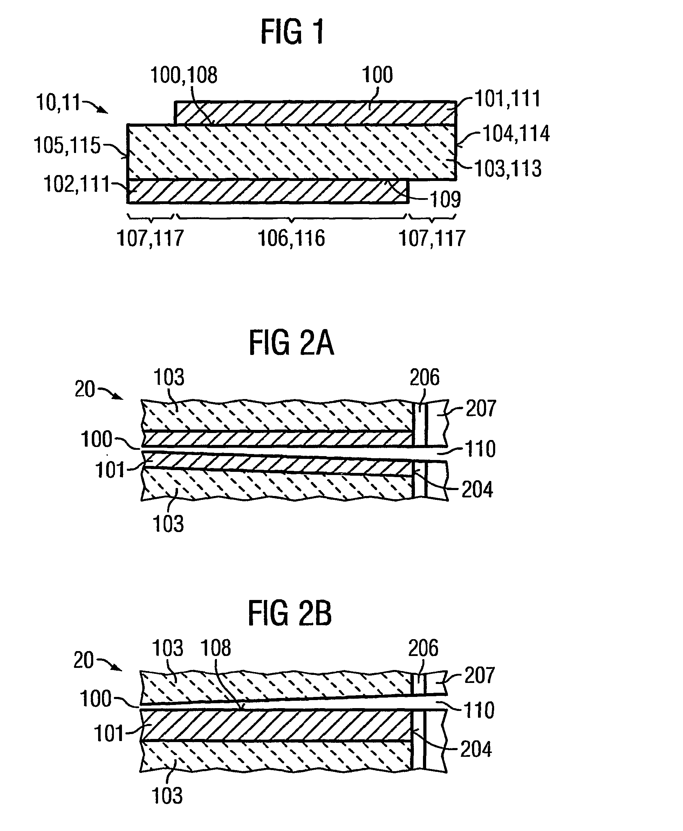

Der Aktorkörper 20 besteht aus übereinander gestapelten Piezoelementen 10 und weiteren Piezoelementen 11 (Figur 1). Ein Piezoelement 10 besteht dabei aus einer Elektrodenschicht 101, mindestens einer weiteren Elektrodenschicht 102 und mindestens einer zwischen den Elektrodenschichten 101 und 102 angeordneten Piezokeramikschicht 103. Die Piezokeramikschicht 103 ist aus einem Bleizirkonattitanat.

Die Elektrodenschichten 101 und 102 sind derart an den Hauptflächen der Piezokeramikschicht 103 angeordnet, dass durch die elektrische Ansteuerung der Elektrodenschichten 101 und 102 ein elektrisches Feld in die Piezokeramikschicht 103 eingekoppelt wird, so dass es zur Auslenkung der Piezokeramikschicht 103 und damit zur Auslenkung des Piezoelements 10 kommt.

Zur elektrischen Kontaktierung sind die Elektrodenschichten 101 und 102 an zwei elektrisch voneinander isolierte, seitliche Oberflächenabschnitte 104 und 105 des Piezoelements 10 geführt. An diesen Oberflächenabschnitten 104 und 105 sind die beiden Elektrodenschichten 101 und 102 jeweils mit einem (in Figur 1 nicht dargestellten) elektrischen Anschlusselement elektrisch kontaktiert. Durch die Führung der Elektrodenschichten 101 und 102 an die voneinander getrennten Oberflächenabschnitte 104 und 105 verfügt das Piezoelement 10 über einen piezoelektrisch aktiven Bereich 106 und mindestens über zwei piezoelektrisch inaktive Bereiche 107.

Die weiteren Piezoelemente 11 sind prinzipiell genauso aufgebaut wie ein Piezoelement 10. Zwischen den weiteren Elektrodenschichten 111 des weiteren Piezoelements 11 ist eine weitere Piezokeramikschicht 113 aus dem Bleizirkonattitanat angeordnet. Die Elektrodenschichten 111 sind an die seitlichen Oberflächenabschnitte 114 und 115 des weiteren Piezoelements 11 geführt und dort elektrisch kontaktiert. Durch die elektrische Ansteuerung der weiteren Elektrodenschichten 111 kommt es zur Auslenkung des weiteren Piezoelements 11. Das weitere Piezoelement ist ebenso ausgestaltet, dass ein weiterer piezoelektrisch aktiver Bereich 116 und piezoelektrisch inaktive Bereiche 117 des weiteren Piezoelements resultieren.

Piezoelemente 10 und weitere Piezoelemente 11 sind derart zu dem monolithischen, stapelförmigen Aktorkörper 20 angeordnet, dass benachbarte Piezoelemente 200 und 201 gemeinsame Elektrodenschicht 202 und 203 aufweisen, die in Stapelrichtung 21 des Aktorkörpers 20 abwechselnd an zwei voneinander elektrisch isolierte, seitliche Oberflächenabschnitte 204 und 205 des Aktorkörpers 20 geführt sind. Der Aktorkörper 20 besteht also aus einer Vielzahl von abwechselnd übereinander gestapelten Piezokeramikschichten und Elektrodenschichten.

Der seitliche Oberflächenabschnitt 204 des Aktorkörpers 20 wird von den seitlichen Oberflächenabschnitten 104 und 114 der Piezoelemente 10 und der weiteren Piezoelemente 11 gebildet. Der weitere seitliche Oberflächenabschnitt 205 des Aktorkörpers 20 wird von den weiteren seitlichen Oberflächenabschnitten 105 und 115 der Piezoelemente 10 und der weiteren Piezoelemente 11 gebildet. Zur elektrischen Kontaktierung der Elektrodenschichten 101 und der weiteren Elektrodenschichten 102 bzw. 111 sind an den seitlichen Oberflächenabschnitten 204 und 205 des Aktorkörpers 20 Metallisierungsbahnen 206 angebracht, an die über Lotbahnen 207 elektrische Anschlusselemente 24 angelötet sind. Jedes der elektrischen Anschlusselemente 24 besteht aus elektrisch leitfähigen Drähten 241, wobei die Drähte 241 zur Beaufschlagung der Elektrodenschichten mit dem gleichen elektrischen Potential an einen gemeinsamen, starren elektrischen Anschlussstift 242 (über die Lotbahnen 243) gelötet sind. Alternativ dazu besteht jedes der Anschlusselemente 24 aus einer strukturierten, elektrisch leitfähigen Metallfolie.

Der Unterschied zwischen einem Piezoelement 10 und einem weiteren Piezoelement 11 besteht darin, dass die Elektrodenschicht 101 des Piezoelements 10 eine Sollbruchstelle 100 aufweist. Dagegen weisen die weiteren Elektrodenschichten 111 des weiteren Piezoelements 11 keine Sollbruchstelle 100 auf.

In einer ersten Ausführungsform wird die Sollbruchstelle 100 ausschließlich von der Elektrodenschicht 101 eines Piezoelements 10 gebildet (Figur 2A). Dazu ist ein Risswiderstand der Elektrodenschicht 101 kleiner als ein Risswiderstand der weiteren Elektrodenschicht 102 des Piezoelements 10 bzw. ein Risswiderstand der Piezokeramikschicht 103 des Piezoelements. Ebenso ist der Risswiderstand der Elektrodenschicht 101 kleiner als der Risswiderstand der weiteren Elektrodenschichten 111 und der Piezokeramikschichten 113 der weiteren Piezoelemente 11. Dadurch ist gewährleistet, dass bei mechanischer Überlastung des Aktorkörpers 20 genau an der Sollbruchstelle 100 des Piezoelements 10 ein Riss 110 entstehen kann. Durch die unterschiedlichen Risswiderstände ist auch dafür gesorgt, dass der Riss 110 im Wesentlichen an der Sollbruchstelle 100 verbleibt. Der Riss 110 kann sich zwar in die am seitlichen Oberflächenabschnitt 204 des Aktorkörper 20 angebrachte Metallisierungsbahn 206 und die aufgebrachte Lotbahn 207 ausbreiten, nicht aber in andere Bereiche des Piezoelements 10 bzw. des Aktorkörpers 20. Der Riss 110 bleibt lokal auf die Sollbruchstelle 100 beschränkt.

In einer weiteren Ausführungsform ist die Sollbruchstelle 100 durch eine Grenzfläche 108 zwischen der Elektrodenschicht 101 und der angrenzenden Piezokeramikschicht 103 des Piezoelements 10 gebildet (Figur 2B). Die Sollbruchstelle 100 ergibt sich dadurch, dass eine Haftfestigkeit der Elektrodenschicht 101 und der Piezokeramikschicht 103 aneinander kleiner ist als die Haftfestigkeit der Piezokeramikschicht 103 und der weiteren Elektrodenschicht 102 aneinander. Ebenso ist die Haftfestigkeit der Elektrodenschicht 101 und der Piezokeramikschicht 103 aneinander kleiner ist die Haftfestigkeit der weiteren Elektrodenschichten 111 und der weiteren Piezokeramikschichten 113 der weiteren Piezoelemente 11 aneinander. Durch die geringere Haftfestigkeit ist dafür gesorgt, dass bei mechanischer Überlastung des Aktorkörper 20 im Wesentlichen nur an der Grenzfläche 108 der Riss 110 entsteht. Gleichzeitig ist dafür gesorgt, dass die angrenzenden Piezokeramikschichten 103 über eine relativ hohe Rissfestigkeit verfügen und somit ein Risswachstum bzw. eine Rissausbreitung in dieses Piezokeramikschichten 103 verhindert wird.

Um unterschiedliche Risswiderstände bzw. Haftfestigkeiten zu erzielen, werden gemäß einer ersten Ausführungsform Elektrodenschichten 101, 102 bzw. 111 mit unterschiedlichen Elektrodenmaterialien verwendet. Gemäß einer dazu alternativen Ausführungsform weisen die Elektrodenschichten unterschiedliche Elektrodenstrukturen auf.

Gemäß einem ersten Ausführungsbeispiel bezüglich des Aktorkörpers 20 ist eine einzige Elektrodenschicht 101 mit einer Sollbruchstelle 100 vorhanden. Der Aktorkörper 20 besteht aus zwei benachbarten Piezoelementen 10 mit der Sollbruchstelle 100 und einer Vielzahl von weiteren Piezoelementen 11, die über keine Sollbruchstelle 100 verfügen. Bei mechanischer Überlastung des Aktorkörpers 20 kommt es zu einer Rissbildung an der Sollbruchstelle 100. Dadurch wird der Aktorkörper 20 in zwei Teilstapel 22 und 23 unterteilt. Die Elektrodenschichten 221 eines Teilstapel 22, die an jeweils einem gemeinsamen Oberflächenabschnitt 204 des Aktorkörpers 20 geführt sind, bleiben bei Auftreten des Risses 110, der sich in die Metallisierungsbahn 206 und die Lotbahn 207 erstreckt, mit den elektrisch leitfähigen Drähten 223 eines elektrischen Teil-Anschlusselements 222 elektrisch kontaktiert.

Dabei genügt zur Gewährleistung der elektrischen Kontaktierung ein einziges Teil-Anschlusselement 222 für jeweils einen gemeinsamen Oberflächenabschnitt 204 der einzelnen Teilstapel 22. Das dafür benötigte Teil-Anschlusselement 222 kann nur einen einzigen, entsprechend dimensionierten elektrisch leitfähigen Draht 223 aufweisen. Alternativ dazu besteht jedes der Teil-Anschlusselemente 222 aus mehreren Drähten 223 oder einer strukturierten Metallfolie. Der Draht bzw. die Drähte und die strukturierte elektrisch leitende Folie sind derart ausgestaltet, dass eine für die Ansteuerung der Elektrodenschichten des Teilstapels 22 des Aktorkörpers 20 notwendige Stromtragfähigkeit gewährleistet ist.

Gemäß einem weiteren Ausführungsbeispiel bezüglich des Aktorkörpers 20 sind mehrere Sollbruchstellen 100 über den Aktorkörper 20 in Stapelrichtung 21 verteilt. Die Sollbruchstellen 100 führen zur Unterteilung des Aktorkörpers 20 in mehrere Teilstapel 22 und 23. Für jeden der Teilstapel 22 und 23 sind entsprechende Teil-Anschlusselemente 222 vorgesehen.

In Weiterbildung eines Aktorkörpers 20 mit mehreren Sollbruchstellen 100 führen bei den Sollbruchstellen 100 unterschiedliche mechanische Überlastungen zur Bildung von Rissen 110. Dabei sind die Sollbruchstellen 100 derart ausgestaltet, dass entlang der Stapelrichtung 21 des Aktorkörpers 20 ein Gradient bezüglich der kritischen Überlastung vorhanden ist, bei der es zur Bildung von Rissen 110 kommt. Dazu weisen die zugehörigen Elektrodenschichten unterschiedliche Risswiderstände auf und/oder es sind die Haftfestigkeiten der Elektrodenschichten an benachbarte Piezokeramikschichten unterschiedlich.

## Patentansprüche

1. Piezoelektrisches Bauteil (1) mit mindestens einem monolithischen Piezoelement (10), aufweisend
- eine Elektrodenschicht (101),
- mindestens eine weitere Elektrodenschicht (102),
- mindestens eine zwischen den Elektrodenschichten (101, 102) angeordnete Piezokeramikschicht (103)
**gekennzeichnet durch**
mindestens eine Sollbruchstelle (100), die bei mechanischer Überlastung des Piezoelements (10) zur Bildung eines bestimmten Risses (110) im monolithischen Piezoelement (10) führt, wobei
- die Sollbruchstelle (100) die Elektrodenschicht (101) aufweist.

2. Bauteil nach Anspruch 1, wobei die Sollbruchstelle (100) von der Elektrodenschicht (101) und/oder von einer Grenzfläche (108) zwischen der Elektrodenschicht (101) und der Piezokeramikschicht (103) gebildet ist.

3. Bauteil nach Anspruch 2, wobei die Sollbruchstelle (100) von der Elektrodenschicht (101) gebildet ist und ein Risswiderstand der Elektrodenschicht (101) kleiner ist als ein weiterer Risswiderstand der weiteren Elektrodenschicht (102).

4. Bauteil nach Anspruch 2, wobei die Sollbruchstelle (100) von der Grenzfläche (108) zwischen der Elektrodenschicht (101) und der Piezokeramikschicht (103) gebildet ist und eine Haftfestigkeit der Elektrodenschicht (101) und der Piezokeramikschicht (103) an der Grenzfläche (108) aneinander kleiner ist als eine weitere Haftfestigkeit der weiteren Elektrodenschicht (102) und der Piezokeramikschicht (103) an einer weiteren Grenzfläche (109) aneinander.

5. Bauteil nach einem der Ansprüche 1 bis 4, wobei sich ein Elektrodenwerkstoff der Elektrodenschicht (101) und ein weiterer Elektrodenwerkstoff der weiteren Elektrodenschicht (102) voneinander unterscheiden.

6. Bauteil nach Anspruch 5, wobei sich der Elektrodenwerkstoff und der weitere Elektrodenwerkstoff in ihrer chemischen Zusammensetzung und/oder in ihrer Gefügestruktur voneinander unterscheiden.

7. Bauteil nach Anspruch 6, wobei die chemische Zusammensetzung ein elektrisch leitfähiges Elektrodenmaterial betrifft.

8. Bauteil nach Anspruch 6 oder 7, wobei die chemische Zusammensetzung einen Zusatzstoff zum elektrisch leitfähigen Elektrodenmaterial betrifft.

9. Bauteil nach einem der Ansprüche 1 bis 8, wobei sich eine Elektrodenstruktur der Elektrodenschicht (101) und eine weitere Elektrodenstruktur der weiteren Elektrodenschicht (102) voneinander unterscheiden.

10. Bauteil nach Anspruch 9, wobei die Elektrodenstruktur eine Elektrodenschichtdicke und die weitere Elektrodenstruktur eine weitere Elektrodenschichtdicke betrifft.

11. Bauteil nach einem der Ansprüche 1 bis 10, bei dem eine Vielzahl von Piezoelementen (10) zu einem monolithischen, stapelförmigen Aktorkörper (20) mit einer Stapelrichtung (21) angeordnet ist.

12. Bauteil nach einem der Ansprüche 1 bis 11, bei dem das Piezoelement (10) und mindestens ein weiteres Piezoelement (11) zu einem monolithischen, stapelförmigen Aktorkörper (20) mit einer Stapelrichtung (21) angeordnet sind, wobei das weitere Piezoelement (11) mindestens zwei weitere Elektrodenschichten (111) und mindestens eine zwischen den weiteren Elektrodenschichten (111) angeordnete weitere Piezokeramikschicht (113) aufweist.

13. Bauteil nach Anspruch 12, wobei eine Vielzahl der Piezoelemente (10) und eine Vielzahl der weiteren Piezoelemente (11) derart zu dem monolithischen, stapelförmigen Aktorkörper (20) angeordnet sind, dass
- benachbarte Piezoelemente (200, 201) jeweils mindestens eine gemeinsame Elektrodenschicht (202, 203) aufweisen und
- die gemeinsamen Elektrodenschichten (202, 203) in Stapelrichtung (21) des Aktorkörpers (20) abwechselnd an mindestens zwei voneinander elektrisch isolierte, seitliche Oberflächenabschnitte (204, 205) des Aktorkörpers (20) geführt sind.

14. Bauteil nach einem der Ansprüche 11 bis 13, bei dem mehrere Piezoelemente (10) derart zu einem Aktorkörper (20) mit einer Anzahl von Sollbruchstellen (100) angeordnet sind, dass die Sollbruchstellen (100) entlang der Stapelrichtung (21) des Aktorkörpers (20) einen Gradienten bezüglich der mechanischen Überlastung aufweisen, bei der es jeweils zu Bildung eines Risses (110) kommt.

15. Bauteil nach einem der Ansprüche 11 bis 14, wobei die Sollbruchstelle (100) zumindest eines der Piezoelemente (10) des Aktorkörpers (20) derart ausgestaltet ist, dass ein in dem Piezoelement (10) auftretender Riss (110) den Aktorkörper (20) in mindestens zwei Teilstapel (22, 23) unterteilt und die Elektrodenschichten (221) des jeweiligen Teilstapels (22), die an einen gemeinsamen seitlichen Oberflächenabschnitt (204) geführt sind, mit Hilfe eines elektrischen Teil-Anschlusselements (222) elektrisch kontaktiert bleiben.

16. Bauteil nach Anspruch 15, wobei das elektrische Teil-Anschlusselement (222) mindestens einen elektrisch leitfähigen Draht (223) aufweist.

17. Bauteil nach Anspruch 15 oder 16, wobei das elektrische Teil-Anschlusselement (222) eine strukturierte elektrisch leitfähige Folie aufweist.

18. Verfahren zum Herstellen eines piezoelektrischen Bauteils (1) nach einem der Ansprüche 1 bis 17, mit folgenden Verfahrensschritten:
a) Bereitstellen einer eine Piezokeramik aufweisenden keramischen Grünfolie mit einer Hauptfläche und einer der Hauptfläche abgekehrten weiteren Hauptfläche,
b) Anordnen von elektrisch leitfähigem Material an der Hauptfläche und Anordnen von weiterem elektrisch leitfähigem Material an der weiteren Hauptfläche der keramischen Grünfolie und
c) gemeinsames Sintern der keramischen Grünfolie und der elektrisch leitfähigen Materialien, wobei aus dem elektrisch leitfähigem Material die Elektrodenschicht, dem weiteren elektrisch leitfähigem Material die weitere Elektrodenschicht und aus der keramischen Grünfolie die Piezokeramikschicht des Piezoelements gebildet werden.

19. Verfahren nach Anspruch 18, wobei zum Anordnen des elektrisch leitfähigen Materials und/oder zum Anordnen des weiteren elektrisch leitfähigen Materials jeweils eine Metallpaste mit unterschiedlicher Zusammensetzung verwendet wird.

20. Verwendung eines piezoelektrischen Bauteils nach einem der Ansprüche 1 bis 17 zum Ansteuern eines Ventils und insbesondere eines Einspritzventils einer Brennkraftmaschine.

## Claims

1. Piezoelectric component (1) comprising at least one monolithic piezo element (10), having
- an electrode layer (101),
- at least one further electrode layer (102),
- at least one piezoceramic layer (103) disposed between the electrode layers (101, 102), **characterised by** at least one predetermined rupture joint (100) which, in the event of mechanical overload of the piezo element (10), leads to the formation of a specific crack (110) in the monolithic piezo element (10), wherein
- the predetermined rupture joint (100) includes the electrode layer (101).

2. Component according to claim 1, wherein the predetermined rupture joint (100) is formed by the electrode layer (101) and/or by an interface (108) between the electrode layer (101) and the piezoceramic layer (103).

3. Component according to claim 2, wherein die predetermined rupture joint (100) is formed by the electrode layer (101) and a crack resistance of the electrode layer (101) is less than a further crack resistance of the further electrode layer (102).

4. Component according to claim 2, wherein the predetermined rupture joint (100) is formed by the interface (108) between the electrode layer (101) and the piezoceramic layer (103) and an adhesive bond mating the electrode layer (101) with the piezoceramic layer (103) at the interface (108) is weaker than a further adhesive bond between the further electrode layer (102) and the piezoceramic layer (103) at a further interface (109).

5. Component according to one of claims 1 to 4, wherein an electrode material of the electrode layer (101) and a further electrode material of the further electrode layer (102) are different.

6. Component according to claim 5, wherein the electrode material and the further electrode material differ in terms of their chemical composition and/or in their material structure.

7. Component according to claim 6, wherein the chemical composition relates to an electrically conductive electrode material.

8. Component according to claim 6 or 7, wherein the chemical composition relates to an ancillary substance in addition to the electrically conductive electrode material.

9. Component according to one of claims 1 to 8, wherein an electrode structure of the electrode layer (101) and a further electrode structure of the further electrode layer (102) differ from each other.

10. Component according to claim 9, wherein the electrode structure relates to an electrode layer thickness and the further electrode structure relates to a further electrode layer thickness.

11. Component according to one of claims 1 to 10, wherein a plurality of piezo elements (10) is arranged to form a monolithic, stack-shaped actuator body (20) with one stacking direction (21).

12. Component according to one of claims 1 to 11, wherein the piezo element (10) and at least one further piezo element (11) are arranged to form a monolithic, stack-shaped actuator body (20) with one stacking direction (21), wherein the further piezo element (11) has at least two further electrode layers (111) and at least one further piezoceramic layer (113) disposed between the further electrode layers (111).

13. Component according to claim 12, wherein a plurality of the piezo elements (10) and a plurality of the further piezo elements (11) are arranged to form the monolithic, stack-shaped actuator body (20) in such a way that
- adjacent piezo elements (200, 201) have at least one common electrode layer (202, 203) in each case and
- the common electrode layers (202, 203) in the stacking direction (21) of the actuator body (20) are brought alternately to at least two lateral surface sections (204, 205) of the actuator body (20) that are electrically insulated from one another.

14. Component according to one of claims 11 to 13, wherein a plurality of piezo elements (10) are arranged to form an actuator body (20) with a number of predetermined rupture joints (100) in such a way that the predetermined rupture joints (100) have a gradient along the stacking direction (21) of the actuator body (20) in respect of the mechanical overload at which a crack (110) will occur in each case.

15. Component according to one of claims 11 to 14, wherein the predetermined rupture joint (100) of at least one of the piezo elements (10) of the actuator body (20) is embodied in such a way that a crack (110) occurring in the piezo element (10) subdivides the actuator body (20) into at least two sub-stacks (22, 23) and the electrode layers (221) of the respective sub-stack (22), which are brought to a common lateral surface section (204), remain electrically contacted with the aid of an electrical sub-connecting element (222).

16. Component according to claim 15, wherein the electrical sub-connecting element (222) has at least one electrically conductive wire (223).

17. Component according to claim 15 or 16, wherein the electrical sub-connecting element (222) has a structured electrically conductive foil.

18. Method for manufacturing a piezoelectric component (1) according to one of claims 1 to 17, comprising the following method steps:
a) provide a ceramic green sheet including a piezoceramic, having a main area and a further main area facing away from the main area,
b) dispose electrically conductive material on the main area and dispose further electrically conductive material on the further main area of the ceramic green sheet and
c) jointly sinter the ceramic green sheet and the electrically conductive materials, the electrode layer being formed from the electrically conductive material, the further electrode layer being formed from the further electrically conductive material, and the piezoceramic layer of the piezo element being formed from the ceramic green sheet.

19. Method according to claim 18, wherein a metallic paste with a different composition in each case is used for arranging the electrically conductive material and/or for arranging the further electrically conductive material.

20. Use of a piezoelectric component according to one of claims 1 to 17 for controlling a valve and in particular an injection valve of an internal combustion engine.

## Revendications

1. Composant piézoélectrique (1) avec au moins un élément piézoélectrique monolithique (10), comprenant
- une couche d'électrode (101)
- au moins une autre couche d'électrode (102)
- au moins une couche de piézocéramique (103) disposée entre les couches d'électrode (101, 102)
**caractérisé par**
- au moins un point destiné à la rupture (100) qui, en cas de surcharge mécanique de l'élément piézoélectrique (10), conduit à la formation d'une fissure définie (110) dans l'élément piézoélectrique monolithique (10),
- le point destiné à la rupture (100) comportant la couche d'électrode (101)

2. Composant selon la revendication 1, dans lequel le point destiné à la rupture (100) est formé par la couche d'électrode (101) et/ou par une interface (108) entre la couche d'électrode (101) et la couche de piézocéramique (103).

3. Composant selon la revendication 3, dans lequel le point destiné à la rupture (100) est formé par la couche d'électrode (101) et dans lequel une résistance à la rupture de la couche d'électrode (101) est plus petite qu'une autre résistance à la rupture de l'autre couche d'électrode (102).

4. Composant selon la revendication 2, dans lequel le point destiné à la rupture (100) est formé par l'interface (108) entre la couche d'électrode (101) et la couche de piézocéramique (103) et dans lequel une résistance d'adhésion de la couche d'électrode (101) et de la couche de piézocéramique (103) l'une sur l'autre à l'interface (108) est plus petite qu'une autre résistance d'adhésion de l'autre couche d'électrode (102) et de la couche de piézocéramique (103) l'une sur l'autre à une autre interface (109).

5. Composant selon l'une quelconque des revendications 1 à 4, dans lequel un matériau d'électrode de la couche d'électrode (101) et un autre matériau d'électrode de l'autre couche d'électrode (102) se distinguent l'un de l'autre.

6. Composant selon la revendication 5, dans lequel le matériau d'électrode et l'autre matériau d'électrode se distinguent dans leur composition chimique et/ou dans leur texture.

7. Composant selon la revendication 6, dans lequel la composition chimique concerne un matériau d'électrode électriquement conducteur.

8. Composant selon la revendication 6 ou 7, dans lequel la composition chimique concerne un matériau additionnel au matériau d'électrode électriquement conducteur.

9. Composant selon l'une quelconque des revendications 1 à 8, dans lequel une structure d'électrode de la couche d'électrode (101) et une autre structure d'électrode de l'autre couche d'électrode (102) se distinguent l'une de l'autre.

10. Composant selon la revendication 9, dans lequel la structure d'électrode concerne une épaisseur de couche d'électrode et l'autre structure d'électrode une autre épaisseur de couche d'électrode.

11. Composant selon l'une quelconque des revendications 1 à 10, dans lequel une multitude d'éléments piézoélectriques (10) sont disposés pour former un corps d'actionneur (20) monolithique en forme de pile avec une direction d'empilement (21).

12. Composant selon l'une quelconque des revendications 1 à 11, dans lequel l'élément piézoélectrique (10) et au moins un autre élément piézoélectrique (11) sont disposés pour former un corps d'actionneur (20) monolithique en forme de pile avec une direction d'empilement (21), l'autre élément piézoélectrique (11) comportant au moins deux autres couches d'électrode (111) et au moins une autre couche de piézocéramique (113) disposée entre les autres couches d'électrode (111).

13. Composant selon la revendication 12, dans lequel une multitude des éléments piézoélectriques (10) et une multitude des autres éléments piézoélectriques (11) sont disposés pour former le corps d'actionneur (20) monolithique en forme de pile de telle sorte que
- des éléments piézoélectriques (200, 201) voisins présentent au moins une couche d'électrode (202, 203) commune et
- les couches d'électrode (202, 203) communes sont guidées alternativement dans la direction d'empilement (21) du corps d'actionneur (20) sur au moins deux tronçons de surface (204, 205) du corps d'actionneur (20), isolés électriquement l'un de l'autre.

14. Composant selon l'une quelconque des revendications 11 à 13, dans lequel plusieurs éléments piézoélectriques (10) sont disposés d'une façon telle pour former un corps d'actionneur (20) avec un nombre de points destinés à la rupture (100) le long de la direction d'empilement (21) du corps d'actionneur (20), que les points destinés à la rupture (100) présentent le long de la direction d'empilement (21) du corps d'actionneur (20) un gradient du point de vue de la surcharge mécanique à laquelle se produit respectivement la formation d'une fissure (110).

15. Composant selon l'une quelconque des revendications 11 à 14, dans lequel le point destiné à la rupture (100) d'au moins un des éléments piézoélectriques (10) du corps d'actionneur (20) est configuré de telle sorte qu'une fissure (110) survenue dans l'élément piézoélectrique (10) divise le corps d'actionneur (20) en au moins deux piles partielles (22, 23) et dans lequel les couches d'électrode (221) de la pile partielle (22) respective, qui sont guidées sur un tronçon latéral commun de surface (204), restent contactés électriquement à l'aide d'un élément de branchement électrique partiel (222).

16. Composant selon la revendication 15, dans lequel l'élément de branchement électrique partiel (222) comporte au moins un fil électriquement conducteur (223).

17. Composant selon la revendication 15 ou 16, dans lequel l'élément de branchement électrique partiel (222) comporte une feuille structurée, électriquement conductrice.

18. Procédé de fabrication d'un composant piézoélectrique (1) selon l'une quelconque des revendications 1 à 17, avec les étapes de procédé suivantes :
a) Mise à disposition d'une feuille céramique crue comportant une piézocéramique avec une surface principale et une autre surface principale détournée de la surface principale,
b) disposition de matériau électriquement conducteur sur la surface principale et disposition d'autre matériau électriquement conducteur sur l'autre surface principale de la feuille céramique crue et
c) frittage commun de la feuille céramique crue et des matériaux électriquement conducteurs, du matériau électriquement conducteur étant formée la couche d'électrode, de l'autre matériau électriquement conducteur étant formée l'autre couche d'électrode, et de la feuille céramique crue étant formée la couche de piézocéramique de l'élément piézoélectrique.

19. Procédé selon la revendication 18, dans lequel, pour la disposition du matériau électriquement conducteur et/ou pour la disposition de l'autre matériau électriquement conducteur est utilisée respectivement une pâte métallique de composition différente.

20. Utilisation d'un composant piézoélectrique selon l'une quelconque des revendications 1 à 17 pour l'excitation d'une soupape et en particulier d'un injecteur d'un moteur à combustion interne.
